(19) **Europäisches Patentamt European Patent Office Office européen des brevets**

(11) **EP 2 082 247 B1**

(12) **FASCICULE DE BREVET EUROPEEN**

(45) Date de publication et mention de la délivrance du brevet:
**16.06.2010 Bulletin 2010/24**

(51) Int Cl.:
**G01R 31/08** *(2006.01)* **G01R 31/11** *(2006.01)*

(21) Numéro de dépôt: **07821594.4**

(86) Numéro de dépôt international:
**PCT/EP2007/061230**

(22) Date de dépôt: **19.10.2007**

(87) Numéro de publication internationale:
**WO 2008/049793 (02.05.2008 Gazette 2008/18)**

(54) **PROCEDE ET DISPOSITIF D'ANALYSE DE RESEAUX DE CABLES ELECTRIQUES PAR SEQUENCES PSEUDO-ALEATOIRES**

VERFAHREN UND EINRICHTUNG ZUM ANALYSIEREN EINES ELEKTRISCHEN KABELNETZES UNTER VERWENDUNG VON PSEUDOZUFALLSSEQUENZEN

METHOD AND DEVICE FOR ANALYSING ELECTRIC CABLE NETWORKS USING PSEUDORANDOM SEQUENCES

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **25.10.2006 FR 0609358**

(43) Date de publication de la demande:
**29.07.2009 Bulletin 2009/31**

(73) Titulaire: **Commissariat à l'énergie atomique et aux énergies alternatives 75015 Paris (FR)**

(72) Inventeurs:
• **RAVOT, Nicolas 77500 Chelles (FR)**
• **BONHOMME, Yannick 91530 Le Val Saint Germain (FR)**
• **AUZANNEAU, Fabrice 91300 Massy (FR)**

(74) Mandataire: **Guérin, Michel Marks & Clerk France Conseils en Propriété Industrielle Immeuble " Visium " 22, avenue Aristide Briand 94117 Arcueil Cedex (FR)**

(56) Documents cités:
WO-A-02/25299          WO-A-02/068968
WO-A-2004/005943     WO-A-2004/005947
GB-A- 1 515 850          US-A- 5 369 366
US-A1- 2004 039 976     US-A1- 2004 073 395

• **HORAN D M ET AL: "A Novel Pulse Echo Correlation Tool for Transmission Path Testing and Fault Finding using Pseudorandom Binary Sequences" DEFECT AND FAULT TOLERANCE IN VLSI SYSTEMS, 2005. DFT 2005. 20TH IEEE INTERNATIONAL SYMPOSIUM ON MONTEREY, CA, USA 03-05 OCT. 2005, PISCATAWAY, NJ, USA,IEEE, 3 octobre 2005 (2005-10-03), pages 229-237, XP010856617 ISBN: 0-7695-2464-8**
• **FURSE C; LO C: "Noise-Domain Reflectometry for Locating Wiring Faults" IEEE TRANSACTIONS ON ELECTROMAGNETIC COMPATIBILITY, vol. 47, no. 1, février 2005 (2005-02), pages 97-104, XP011127068 New York, US cité dans la demande**
• **CYNTHIA FURSE, PAUL SMITH, CHET LO, YOU CHUNG CHUNG, PRAVEEN PENDAYALA, KEDARNATH NAGOTI: "Spread spectrum sensors for critical fault location on live wire networks" STRUCTURAL CONTROL AND HEALTH MONITORING, vol. 12, no. 3-4, juillet 2005 (2005-07), - décembre 2005 (2005-12) pages 257-267, XP009085800 cité dans la demande**
• **TAYLOR V ET AL: "Line monitoring and fault location using spread spectrum on power line carrier" IEE PROCEEDINGS: GENERATION, TRANSMISSION AND DISTRIBUTION, INSTITUTION OF ELECTRICAL ENGINEERS, GB, vol. 143, no. 5, 13 septembre 1996 (1996-09-13), pages 427-434, XP006006488 ISSN: 1350-2360**

- **NISHIYAMA E ET AL: "Development of monitoring equipment of currents and voltages of power-transmission lines" IEEE/PES TRANSMISSION AND DISTRIBUTION CONFERENCE AND EXHIBITION 2002 : ASIA PACIFIC. YOKOHAMA, JAPAN, OCT. 6 - 10, 2002, IEEE/PES TRANSMISSION AND DISTRIBUTION CONFERENCE AND EXPOSITION, NEW YORK, NY : IEEE, US, vol. VOL. 1 F 3, 6 octobre 2002 (2002-10-06), pages 2310-2316, XP010630252 ISBN: 0-7803-7525-4 cité dans la demande**
- **NISHIYAMA E ET AL: "Fault detection for power transmission line by use of M-sequence correlation" IEEE/PES TRANSMISSION AND DISTRIBUTION CONFERENCE AND EXHIBITION 2002 : ASIA PACIFIC. YOKOHAMA, JAPAN, OCT. 6 - 10, 2002, IEEE/PES TRANSMISSION AND DISTRIBUTION CONFERENCE AND EXPOSITION, NEW YORK, NY : IEEE, US, vol. VOL. 1 F 3, 6 octobre 2002 (2002-10-06), pages 465-469, XP010631438 ISBN: 0-7803-7525-4**
- **NEWTON S A: "Novel approaches to optical reflectometry" CONFERENCE PROCEEDINGS ARTICLE, 13 février 1990 (1990-02-13), pages 329-333, XP010000232**

**Description**

L'invention concerne un procédé et un dispositif d'analyse de câbles électriques en réseau, pour la détection, la caractérisation et la localisation de défauts dans les câbles de ce réseau.

Les câbles électriques concernés peuvent être des câbles de transmission d'énergie ou des câbles de communication, dans des installations fixes (réseau de distribution, réseau de communication intérieur ou extérieur) ou mobiles (réseau d'énergie ou de communication dans un avion, un bateau, une automobile, etc.). Les câbles peuvent être quelconques : coaxiaux ou bifilaires, en lignes parallèles ou en paires torsadées, blindés ou non, etc., pourvu que la vitesse de propagation des signaux dans ces câbles puisse être connue. Ces réseaux peuvent être organisés selon différentes topologies connues : en bus, arbre, maillé, en anneau, étoile, linéaire, ou mixtes de ces différentes topologies.

Les défauts concernés sont des défauts pouvant affecter le fonctionnement électrique des circuits dont les câbles font partie et pouvant avoir des conséquences parfois très critiques (pannes de systèmes électriques dans un avion par exemple), ou même des défauts pouvant directement engendrer des débuts d'incendie (court-circuits, arcs électriques en milieu sec ou en présence d'humidité, etc.). Il est important de pouvoir détecter ces défauts pour y remédier à temps.

On comprend que le problème de la détection des défauts est d'autant plus important que les réseaux de câbles électriques sont plus longs et plus complexes ou qu'ils sont plus difficiles d'accès (câbles enterrés par exemple). C'est pourquoi on a imaginé des systèmes de détection et de localisation à distance, fonctionnant à partir d'une extrémité du câble. Les méthodes utilisées sont des méthodes dites de réflectométrie, dans lesquelles un signal injecté à une extrémité d'un câble se propage dans ce câble et une partie de l'amplitude du signal est réfléchie à l'endroit du défaut, en raison de la discontinuité d'impédance que le signal rencontre à cet endroit. Si la vitesse de propagation des signaux dans le câble (liée à son impédance caractéristique) est connue, la mesure de la durée qui sépare l'onde émise de l'onde réfléchie donne une indication de la distance entre l'extrémité du câble et le défaut.

Dans les méthodes de réflectométrie temporelle (TDR pour "Time-Domain Reflectometry"), on injecte une onde électromagnétique dans le câble sous la forme d'une impulsion de tension, d'un échelon de tension, ou autre. L'onde réfléchie à l'endroit de la discontinuité d'impédance est détectée à l'endroit de l'injection et on mesure l'écart temporel entre les fronts émis et reçus. La position du défaut est déterminée à partir de cet écart, et l'amplitude et la polarité de l'impulsion réfléchie donnent une indication du type de défaut (circuit ouvert, court-circuit, défaut résistif, ou autre).

Il existe aussi des méthodes de réflectométrie dans le domaine fréquentiel (FDR pour "Frequency Domain Reflectometry"), qui consistent à injecter à l'entrée du câble une sinusoïde wobulée en fréquence en continu ou par échelons et à mesurer l'écart de fréquence ou de phase entre l'onde émise et l'onde réfléchie. La demande de brevet publiée WO 02/068968 décrit une méthode de réflectométrie dans le domaine fréquentiel. Dans une variante appelée SWR pour "Standing Wave Reflectometry", on détecte les noeuds et ventres d'une onde stationnaire engendrée par la combinaison d'une onde incidente et de sa réflexion.

Les méthodes de réflectométrie dans le domaine fréquentiel sont efficaces pour analyser un câble simple. Elles sont difficilement utilisables lorsque le câble comporte des dérivations. Les méthodes de réflectométrie dans le domaine temporel peuvent être utilisées même avec des dérivations mais l'analyse des signaux réfléchis est difficile en raison de la présence de réflexions multiples.

On a également proposé, dans la demande de brevet publiée WO 2004/005947, une méthode à la fois temporelle et fréquentielle consistant à injecter un signal wobulé linéairement avec une enveloppe d'amplitude gaussienne.

On a aussi proposé des méthodes de réflectométrie à étalement de spectre, dans l'article "Spread Spectrum Sensors for Critical Fault Location on Live Wire Networks" par Cynthia Furse et autres, dans Journal of Structural Control and Health Monitoring, Volume 12, Issue 3-4, 2005. On transmet un signal sous forme d'un code pseudo-aléatoire de bas niveau sur un réseau, même lorsqu'il est en service ; ce signal et son écho réfléchi par le défaut éventuel sont corrélés avec des décalages temporels variables pour établir une courbe de corrélation en fonction du temps. Cette courbe présente des pics de corrélation à des décalages temporels liés à la position des défauts et des jonctions et/ou dérivations du réseau. Ce système est particulièrement adapté à la détection de défauts intermittents car il peut fonctionner même alors que le réseau est utilisé ; or, les défauts intermittents peuvent très bien ne se produire que lorsque le réseau est en service et disparaître lorsqu'il ne l'est plus (par exemple un défaut qui se produirait pendant qu'un avion vole mais qui disparaîtrait au sol). Cette méthode peut être utilisée pour des câbles comportant des dérivations, mais elle conserve des ambiguïtés : on ne sait pas dire sur quelle branche se situe un défaut détecté. Le brevet US 5 369 366 décrit une telle méthode.

L'article de Eiji Nishiyama et Kenshi Kuwanami dans la revue IEEE 2002 0-7803-7525-4/02 pp 465 à 468 décrit brièvement une méthode utilisant l'injection de séquences pseudo-aléatoires en un ou plusieurs points d'un réseau linéaire simple en boucle fermée.

Une méthode similaire mais utilisant tout simplement les signaux ou le bruit naturel circulant dans le câble, et non pas un code pseudo-aléatoire injecté à l'entrée du câble, a été proposée dans l'article de Chet Lo et Cynthia Furse "Noise-Domain Reflectometry for Locating Wiring Faults" publié dans IEEE Transactions on Electromagnetic Compatibility, Vol 47 N°1 Février 2005. Des pics de forte corrélation sont détectés dans un processus de corrélation du signal avec lui-même. Cette méthode souffre du même défaut que la précédente, c'est-à-dire qu'elle ne permet pas facilement de lever les ambiguïtés de position lorsqu'il y a plusieurs branches.

L'invention a pour but d'aider à lever les ambiguïtés de détermination de position de défauts des méthodes antérieures, notamment dans les câbles présentant une structure en T (également appelée structure en Y), c'est-à-dire comportant au moins une dérivation.

Pour y parvenir, l'invention propose un procédé de test d'un réseau de câbles comportant au moins une jonction d'où partent N tronçons secondaires (N supérieur ou égal à 2), le procédé comprenant les opérations suivantes :

- injecter dans le réseau, en plusieurs points d'injection Ei, des séquences pseudo-aléatoires de signaux numériques PNi(t),
- recueillir, en un ou plusieurs points d'observation Sj, des signaux temporels composites Rj(t) engendrés par la propagation des séquences émises et leurs réflexions dans les discontinuités d'impédance du réseau,
- calculer une fonction de corrélation Kij($\tau$), en chacun des points d'observation Sj et pour chaque point d'injection Ei, cette fonction représentant, en fonction d'un retard variable $\tau$, une valeur de corrélation temporelle entre d'une part le signal composite Rj(t) présent en ce point d'observation et d'autre part des séquences pseudo-aléatoires PNi(t-$\tau$) identiques aux séquences PNi(t) qui sont injectées aux différents points mais retardées du retard variable $\tau$,
- rechercher des valeurs caractéristiques de $\tau$ pour lesquelles la courbe de corrélation Kij($\tau$) présente un pic,
- déterminer les positions de défauts du câble en fonction des valeurs caractéristiques trouvées pour chaque corrélation Kij($\tau$),
- les séquences pseudo-aléatoires injectées aux différents points étant non corrélées entre elles.

Ainsi, au lieu d'injecter une même séquence en plusieurs points du réseau, on injecte des séquences différentes et non corrélées entre elles. Par séquences non corrélées, on entend des séquences soit complètement dé-corrélées, soit peu corrélées, c'est-à-dire que leur inter-corrélation en fonction d'un retard $\tau$ ne produit pas de pic de corrélation significatif d'amplitude comparable au pic d'auto-corrélation d'une séquence avec elle-même. En d'autres mots la corrélation de deux séquences peu corrélées produit essentiellement du bruit et non pas des pics de corrélation caractéristiques tels que ceux qui sont générés par une séquence et la réflexion de cette même séquence sur une discontinuité d'impédance du réseau.

Les séquences peuvent être des séquences dites séquences pseudo-aléatoires de type M, ou encore "séquences pseudo-aléatoires à longueur maximale" ; ce sont des séquences produites par une cascade de n registres à décalage avec un rebouclage de la cascade sur elle-même et des rebouclages intermédiaires à partir de la sortie de certains registres au milieu de la cascade (en anglais Linear Feedback Shift Register ou LFSR).

La faible corrélation peut être obtenue notamment en établissant des séquences numériques pseudo-aléatoires de longueur différente (établies par des générateurs ayant des nombres de registres différents), ou des séquences ayant des débits binaires suffisamment différents, dont le rapport n'est pas un entier et est de préférence

- un nombre irrationnel,
- ou à la rigueur une fraction rationnelle de nombres entiers.

Les séquences peuvent aussi être dé-corrélées par nature en choisissant des séquences pseudo-aléatoires orthogonales, tels que des codes utilisés pour la séparation des canaux de satellites de GPS ou pour la séparation de canaux de télécommunications par étalement de spectre (codes de Gold par exemple).

Des séquences pseudo-aléatoires peuvent être générées à partir de polynômes caractéristiques de degré n (n étant égal au nombre de registre du LFSR). Pour en exploiter au mieux les capacités et générer des séquences de longueur maximale, le polynôme caractéristique devra être irréductible et dans ce cas la période du LFSR sera égale à T0 = $2^n$ - 1 (exprimé en nombres de bits de la séquence). Pour une longueur de séquence donnée et un débit donné, une faible corrélation peut être obtenue en choisissant des polynômes caractéristiques différents. En pratique, un nombre n minimum de registres est requis pour que les polynômes soient dé-corrélés entre eux. Par exemple si :

- n = 4 il n'existe que deux polynômes caractéristiques primitifs, et ils ne sont pas suffisamment dé-corrélés entre eux ;
- n = 6 : il existe 6 polynômes caractéristiques primitifs ;
- à partir de n = 8 les polynômes caractéristiques sont de longueur suffisante pour être tous dé-corrélés entre eux ;

Un critère pour évaluer si deux séquences sont suffisamment dé-corrélées entre elles est de mesurer si leur ratio d'inter-corrélation (niveau du pic maximal d'inter-corrélation entre deux séquences différentes/niveau du pic maximal d'auto-corrélation de la même séquence) est inférieur typiquement à 5 à 10 % :

$$[\text{MaxIntercorrélation-MinIntercorrélation}]/[\text{MaxAutocorrélation}]<=0,10$$

Le dispositif de mise en oeuvre de ce procédé comprend donc aux moins deux sources de séquences pseudo-aléatoires de signaux numériques non corrélées entre elles et aptes à être raccordées en deux points d'un réseau à tester, des moyens de synchronisation des sources entre elles, un dispositif de détection du signal composite présent en au moins un point du réseau, et des moyens de calcul de la fonction de corrélation entre ce signal et chacune des séquences pseudo-aléatoires retardées d'un retard variable ($\tau$).

D'autres caractéristiques et avantages de l'invention apparaîtront à la lecture de la description détaillée qui suit et qui est faite en référence aux dessins annexés dans lesquels :

- la figure 1 représente à titre d'exemple un réseau de câbles à dérivation que l'on souhaite analyser ;
- la figure 2 représente un réflectogramme temporel traditionnel susceptible d'apparaître lors d'une analyse du réseau par injection d'une impulsion ;
- la figure 3 représente un générateur de séquence pseudo-aléatoire de type M ;
- la figure 4 représente la fonction d'auto-corrélation temporelle d'une séquence pseudo-aléatoire de type M ;
- la figure 5 représente une séquence pseudo-aléatoire temporelle PN(t) ;
- la figure 6 représente un signal composite R(t) issu de la propagation de la séquence pseudo-aléatoire dans un réseau ;
- la figure 7 représente un exemple de courbe de corrélation temporelle K11 ($\tau$) entre un signal tel que celui de la figure 6 et une séquence pseudo-aléatoire qui l'a engendré;
- la figure 8 représente les fonctions de corrélation temporelle Kii($\tau$) entre le signal composite présent à chaque extrémité du réseau et la séquence pseudo-aléatoire respective injectée à cette même extrémité ;
- la figure 9 représente les fonctions de corrélation temporelle Kij($\tau$) entre les signaux composites Rij(t) recueillis sur une extrémité et les séquences pseudo-aléatoires injectées à cette extrémité et aux autres extrémités.

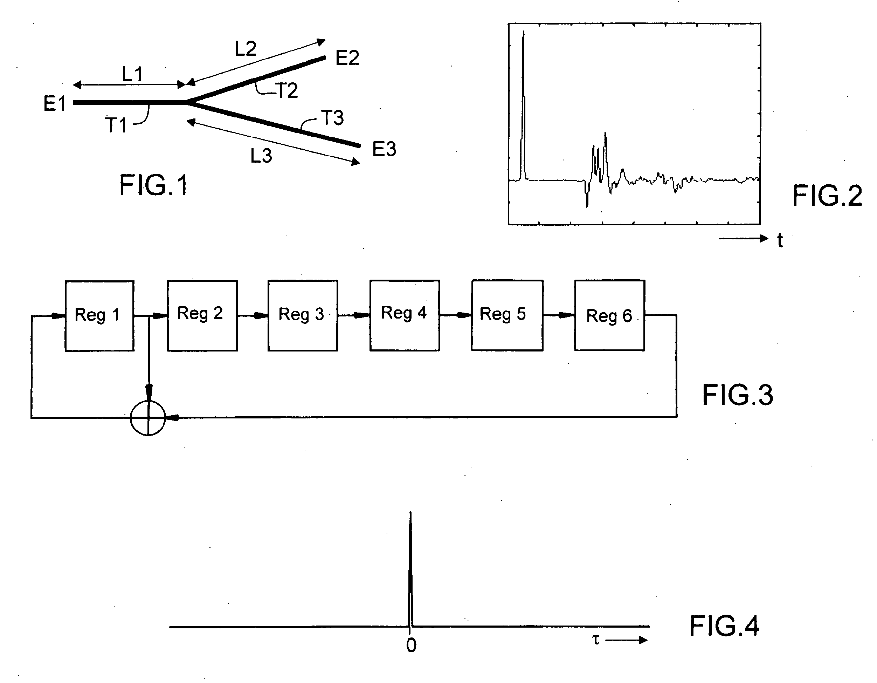

Sur la figure 1, on a représenté schématiquement un réseau à une jonction et deux dérivations, ayant trois tronçons T1, T2 et T3. Les tronçons T2 et T3 ont une extrémité d'entrée raccordée à un point de jonction A situé à une extrémité de sortie du tronçon T1. Ainsi, si on suit le réseau en partant d'une extrémité d'entrée E1 de celui-ci, on rencontre successivement une longueur de câble L1 du tronçon T1, puis une jonction en A, et, selon qu'on suit le tronçon T2 ou le tronçon T3, respectivement une longueur de câble L2 du tronçon T2 jusqu'à son extrémité de sortie E2, ou une longueur de câble L3 du tronçon T3 jusqu'à son extrémité de sortie E3.

Il s'agit là d'un exemple simple de réseau en T (ou Y). Les tronçons considérés et représentés par un trait peuvent être constitués par un fil conducteur gainé ou une paire de fils gainés ou un câble coaxial. Ce réseau peut servir indifféremment à transporter de l'énergie ou des signaux de communication de l'entrée E1 vers les sorties E2 et E3, ou dans le sens contraire depuis une sortie E2 ou E3 vers l'autre sortie ou vers l'entrée E1. C'est pourquoi on appellera ci-après "extrémités" du réseau les entrées et sorties E1, E2, E3, sachant que chacune d'entre elles peut jouer aussi bien un rôle d'entrée qu'un rôle de sortie et ceci en utilisation normale du réseau ou lors de la recherche de défauts du réseau ; il est à noter que la recherche de défaut peut très bien, dans la présente invention, se faire en même temps que l'utilisation normale.

Les extrémités de tronçons E1, E2, E3 peuvent être en circuit-ouvert, ou en court-circuit, ou chargées par une impédance adaptée ou non adaptée. S'il y a adaptation d'impédance il n'y a pas de réflexion des signaux de test sur ces extrémités. S'il y a court-circuit, il n'y a pas de transmission au delà du court-circuit et il y a réflexion en négatif. S'il y a circuit ouvert, il y a réflexion sans atténuation ou presque. S'il y a désadaptation d'impédance, il y a réflexion partielle.

Dans les méthodes classiques de détection de défauts, on appliquerait typiquement une impulsion de test à partir de l'entrée E1, et on recueillerait sur cette même entrée un motif de signaux appelé "réflectogramme temporel" ; le réflectogramme est le tracé d'une courbe représentant l'évolution d'une amplitude de tension relevée à l'entrée E1 au cours du temps.

La figure 2 représente un tel réflectogramme pour le câble de la figure 1, avec le temps en abscisse et une amplitude de tension en ordonnée. L'impulsion d'entrée, à gauche sur le diagramme, est une impulsion positive de courte durée par rapport aux durées de propagation dans les câbles afin que les impulsions réfléchies ne se mélangent pas avec l'impulsion émise. Les impulsions réfléchies sont d'abord une impulsion de réflexion négative à la jonction ; la jonction crée une désadaptation d'impédance dans laquelle l'impédance vue est plus faible que l'impédance caractéristique du câble, d'où l'amplitude négative du signal réfléchi. Puis on trouve une impulsion positive réfléchie par l'extrémité en circuit ouvert (impédance élevée) du tronçon T2, puis une impulsion qui semble issue d'un trajet aller-retour entre la jonction A et l'extrémité E2 du deuxième tronçon. Puis se produit une impulsion due à la réflexion à l'extrémité E3 du troisième tronçon. Ensuite, les impulsions issues d'autres réflexions multiples ou combinées apparaissent, par exemple une impulsion résultant de la réflexion, à l'extrémité du tronçon T2, d'une impulsion déjà réfléchie par l'extrémité du troisième tronçon. Les premières impulsions sont les plus significatives, les autres sont plus difficiles à exploiter.

Si un défaut est présent dans l'un des tronçons, il peut avoir pour effet de déplacer certaines des impulsions ou tout simplement de rajouter des impulsions au diagramme de la figure 2. Il n'est donc pas facile d'interpréter l'existence d'un défaut et de trouver la localisation du défaut à partir d'un tel réflectogramme.

Dans le procédé selon l'invention on n'injecte pas une impulsion en un point mais on injecte des séquences pseudo-aléatoires de signaux binaires, en plusieurs points du réseau (de préférence les extrémités existantes E1, E2, E3), les différentes séquences étant dé-corrélées les unes d'avec les autres.

Une séquence pseudo-aléatoire est constituée par une série, plus ou moins longue, de bits dont la distribution est aléatoire, cette distribution étant telle qu'une corrélation de cette séquence avec la même séquence retardée d'un temps $\tau$ donne un pic de corrélation très étroit autour de $\tau = 0$ ; en dehors de ce pic étroit (largeur pratiquement égale à la durée de deux bits de la séquence), la valeur de corrélation est nulle ou en tous cas très faible devant l'amplitude du pic.

Une telle séquence est généralement produite par la mise en cascade de plusieurs registres à décalage, un rebouclage de la cascade sur elle-même, et des opérations OU-Exclusif et/ou des rebouclages intermédiaires à partir des sorties des registres.

Parmi les séquences pseudo-aléatoires, il y a notamment les séquences dites séquences M ou séquences à longueur maximale, qui, à partir de n registres en cascade, forment des séquences de longueur $2^n-1$ bits. La figure 3 représente un exemple avec 6 registres en cascade constituant un LFSR ou registre à décalage linéaire bouclé (de l'anglais "Linear Feedback Shift Register"). Par exemple, avec 6 registres on produit des séquences périodiques de 63 bits, d'une durée de l'ordre d'une microseconde environ si le débit binaire est d'environ 50Mbps (megabits par seconde). De telles séquences sont utilisables dans le procédé selon l'invention.

La figure 4 représente la corrélation d'une séquence M avec cette même séquence retardée d'un temps variable $\tau$ (en abscisse). Le calcul de corrélation fournit un signal quasi-nul sauf pour une valeur de $\tau$ dans un intervalle très étroit (largeur égale à la durée de deux bits) où elle présente un pic élevé ; le centre du pic est situé à $\tau=0$, pour lequel la corrélation est maximale. Si la séquence est périodiquement ré-émise, un pic de corrélation existe bien sûr à chaque période. L'émission de séquences périodiques est préférée si les séquences sont assez courtes, car cela favorise la corrélation entre la séquence et les signaux qui circulent dans le câble.

La période temporelle d'une séquence est définie comme suit :

$$T0 = [2^n-1]/D$$

où n est le nombre de registres ou le degré du polynôme caractéristique et D le débit de la séquence.

Pour obtenir des séquences dé-corrélées entre elles, on peut choisir des séquences:

- de débit différent et de degré n identique ;
- de débit identique et de degré n différent ;
- ou, selon un mode de réalisation préféré de l'invention, des séquences de degré n identiques et de même débit, en choisissant des polynômes caractéristiques primitifs différents pour chaque LFSR.

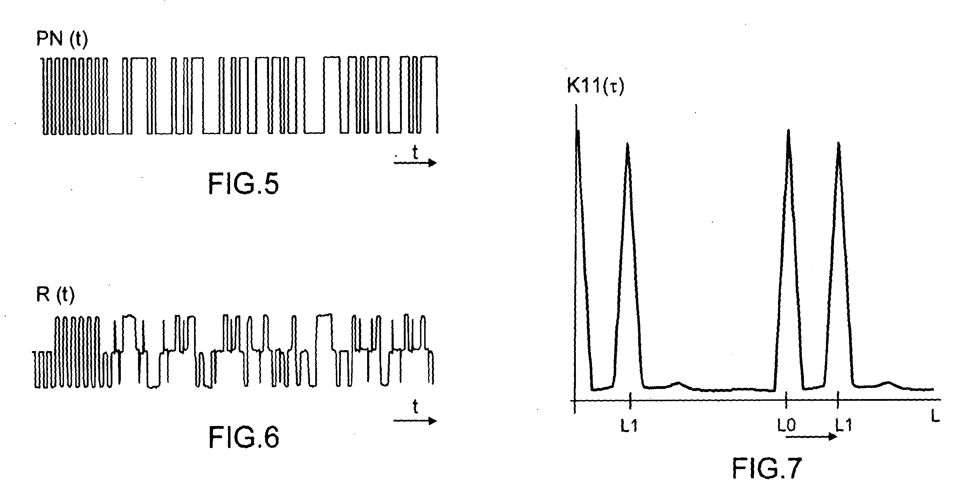

La figure 5 représente à titre d'illustration une séquence binaire pseudo-aléatoire PN(t) émise à 50 Mbps et durant 1 microseconde.

Une telle séquence binaire pseudo-aléatoire peut être émise à une extrémité d'un réseau comme par exemple l'entrée E1 du réseau de la figure 1. Elle se propage dans le réseau, perd un peu de son énergie, peut rencontrer des discontinuités d'impédance (jonctions, dérivation, court-circuits, circuits ouverts, charges non adaptées, défauts dans le câble), peut se réfléchir partiellement sur ces discontinuités, peut se propager en partie au-delà, rencontrer d'autres discontinuités, etc. et atteint les différentes extrémités du réseau, y compris l'extrémité de départ où elle a été injectée.

De ces phénomènes de propagation avec pertes et réflexions partielles il résulte qu'un signal composite réapparaît à l'entrée E1, et ce signal composite, analogique plus que numérique, est la superposition de la séquence initialement injectée et de plusieurs signaux qui représentent chacun la même séquence mais retardée et atténuée par les propagations et réflexions successives.

La résultante de ces séquences identiques mais de niveaux variables et de retards différents produit un signal composite tel que par exemple celui de la figure 6. Si on corrèle ce signal composite présent à l'entrée E1 avec la séquence initiale injectée dans cette entrée, en retardant celle-ci d'une durée variable $\tau$, on peut tracer une courbe de corrélation fonction du retard $\tau$. On va trouver un pic de corrélation maximal pour une durée $\tau=0$ si on prend comme référence de retard 0 l'instant où la séquence est injectée dans l'entrée, puisque la séquence injectée est présente sans décalage à cet instant, et un nouveau pic de corrélation maximale à chaque période T0 d'injection de nouvelle séquence si la séquence est injectée périodiquement ; le pic à τ = 0 provient du fait que le signal mesuré est la somme du signal émis et du signal reçu mais c'est dû au système de mesure ; et on va trouver d'autres pics de corrélation chaque fois qu'une réflexion ou une suite de réflexions ramène à l'entrée E1 un signal qui comporte des ressemblances de structure binaire avec la séquence initiale.

Plutôt que de graduer l'abscisse de la courbe de corrélation en retard τ, on peut la graduer en distance L le long du réseau à partir du point d'injection de la séquence, la correspondance étant L=Vp.τ/2, ou Vp est la vitesse de propagation des signaux numériques dans le réseau et le facteur 1/2 étant là pour tenir compte du fait que le trajet de la séquence comporte un aller-retour entre le point d'injection et le point de discontinuité.

La figure 7 représente un exemple d'une telle courbe de corrélation K11 (τ) dans le cas d'un tronçon de ligne simple de longueur L1 en circuit ouvert à ses extrémités. L'abscisse est la distance L= Vp.τ/2 entre l'extrémité d'injection E1 et l'autre extrémité, et l'ordonnée est la valeur de corrélation K11 (τ), entre la séquence injectée à l'extrémité E1 et le signal recueilli en E1. Le premier pic de corrélation correspond à l'instant d'injection, c'est-à-dire un retard τ = 0. La séquence est injectée périodiquement avec une période T0 (correspondant à une distance L0=Vp.T0/2) et on voit donc un autre pic de corrélation maximale à L0. Les autres pics représentent le retour de la séquence après réflexion sur la deuxième extrémité du tronçon après l'injection d'une séquence ; ils se situent donc à une distance L1 de chaque pic d'injection. La graduation en ordonnée est arbitraire.

La fonction de corrélation est obtenue par calcul, à partir du signal composite temporel numérisé R1 (t) présent en E1 et à partir de la séquence pseudo-aléatoire PN1 (t) dont la structure, la longueur et le débit (50 Mbps par exemple) sont connus.

Le coefficient de corrélation K11 (τ), en ordonnée de la figure 7, est le résultat du calcul de corrélation qui est l'intégration, sur une durée T partant d'un instant -T/2 et allant à un instant +T/2, du produit de la séquence pseudo-aléatoire PN1 (t-τ) injectée en E1 par le signal composite R1(t) recueilli en E1:

$$K11(\tau) = 1/T \int_{-T/2}^{+T/2} R1(t).PN1(t-\tau).dt$$

T peut correspondre à une ou plusieurs périodes de séquences successives.

C'est cette fonction de corrélation qui peut présenter les pics visibles à la figure 7, la variable d'abscisse étant L= Vp.τ/2.

Ce calcul est valable pour n'importe quel réseau et à partir de n'importe quel point d'injection, pourvu qu'on observe le signal composite au point d'injection lui-même.

Dans le réseau simple de la figure 1 supposé sans défaut, si les extrémités E2 et E3 sont adaptées en impédance on trouvera un pic de corrélation au temps 0 et un pic reflétant la réflexion sur la jonction A. Si les extrémités E2 et E3 n'étaient pas adaptées, on trouverait d'autres pics reflétant les discontinuités d'impédance ; typiquement, si les extrémités E2 et E3 étaient en circuit ouvert, on aurait au moins un pic de corrélation pour chacune des valeurs

$$\tau_a = 2L1/Vp \quad \text{à cause de la jonction A}$$

$$\tau_b = 2(L1+L2)/Vp \text{ due à l'extrémité E2}$$

$$\tau_c = 2(L1+L3)/Vp \text{ due à l'extrémité E3}$$

S'il y a un défaut à une distance Ld de l'entrée E1, on aurait au moins un pic de corrélation pour un retard correspondant à la propagation sur une distance 2Ld, c'est-à-dire à $\tau_d$ = 2Ld/Vp. L'existence d'un tel pic ne permet pas de savoir facilement où est le défaut dès lors que Ld est supérieur à L1 (défaut au-delà de la jonction A).

Cependant, ce signal injecté en E1 engendre en E2 et E3 d'autres signaux composites ayant une ressemblance avec le signal numérique injecté PN1 (t), et ces signaux R2(t), R3(t) peuvent être corrélés avec la séquence injectée pour donner des pics de corrélation qui instruisent aussi sur la structure du réseau ou qui confirment les indications données par la première fonction de corrélation K11 (τ).

Ainsi, si on fait la corrélation entre R2(t) et PN1 (t) on doit voir un pic de corrélation à un instant $\tau_{L1+L2}$ = (L1+L2)/Vp puisque ce retard $\tau_{L1+L2}$ est le temps mis par la séquence pour arriver directement de l'extrémité E1 vers l'extrémité

E2 (le retard $\tau$ = 0 étant pris avec la même référence que pour la première corrélation). De même on doit voir un pic de corrélation entre le signal composite R3(t) en E3 et la séquence PN1(t) émise en E1, ce pic étant centré sur un instant $\tau_{L1+L3}$ = (L1+L3)/Vp.

Mais de la même manière, on peut aussi injecter aux extrémités E2 et E3 deux autres séquences pseudo-aléatoires PN2(t) et PN3(t), et on peut corréler le signal composite R1(t) alors présent au point E1 avec chacune de ces séquences pseudo-aléatoires, pour aboutir à des fonctions de corrélation respectives K21($\tau$) qui est la corrélation du signal composite R1(t) présent en E1 avec la séquence PN2(t) émise en E2, et K31($\tau$) qui est la corrélation du signal composite R1(t) présent en E1 avec la séquence PN3(t) émise en E3. Si la référence de retard $\tau$=0 est prise au même instant de référence (instant d'injection de la séquence PN1(t)), alors on devrait voir apparaître dans les fonctions de corrélation K21 ($\tau$) et K31 ($\tau$) respectivement un pic de corrélation à un instant $\tau_{L1+L2}$ = (L1+L2)/Vp et un pic à un instant $\tau_{L1+L3}$ = (L1+L3)/Vp, le réseau étant supposé sans défaut entre E1, E2, et E3.

Selon l'invention, ces autres séquences pseudo-aléatoires ne sont pas corrélées entre elles ni corrélées avec la première, afin que les fonctions de corrélation calculées permettent de distinguer complètement d'où viennent les séquences donnant lieu à des pics de corrélation.

Plus généralement, on va donc prendre N points d'injection Ei, qui sont normalement les extrémités accessibles du réseau (mais qui pourraient être d'autres points), et y injecter N séquences pseudo-aléatoires de signaux binaires non corrélées entre elles, PNi(t), i variant de 1 à N ; on va effectuer des calculs de corrélation entre chaque séquence PNi(t) et chacun des signaux composites Rj(t) qui apparaissent sur K points d'observation Sj, j variant de 1 à K. Les points d'observation sont de préférence les points d'injection. De ces calculs on déduit ensuite des informations plus précises (c'est-à-dire moins ambiguës) que les informations données par les pics de corrélation de la seule séquence PN1 (t).

En un point d'observation Sj, on effectue les calculs de corrélation suivants, pour certains ou tous les indices i et j associés aux points d'injection et aux points d'observation :

$$Kij(\tau) = 1/T \int_{-T/2}^{+T/2} Rj(t).PNi(t-\tau).dt,$$

y compris bien sûr le calcul pour i=j, à savoir :

$$Kii(\tau) = 1/T \int_{-T/2}^{+T/2} Ri(t).PNi(t-\tau).dt$$

Ces calculs permettent de tracer des courbes de corrélation en fonction de $\tau$ et de trouver des pics de corrélation.

Si les séquences pseudo-aléatoires injectées étaient les mêmes, on aboutirait, dans le cas du réseau de la figure 1 supposé sans défaut, à des courbes de corrélation difficiles à interpréter ; en effet, en un point d'observation parviennent des séquences propagées qui peuvent provenir de n'importe quel point d'injection puisque toutes contiennent de manière intrinsèque une forme résultant d'une même séquence initiale. Les pics de corrélation sont donc nombreux et ambigus.

Mais si les séquences pseudo-aléatoires présentent une inter-corrélation nulle ou très faible entre elles, les différentes corrélations avec les signaux composites sont distinguables les unes des autres. Les différentes fonctions de corrélation calculées en un même point d'observation Sj feront apparaître séparément des pics résultant des différents points d'injection des séquences. C'est par rapport à ce point d'injection que seront mesurées les positions des discontinuités d'impédance.

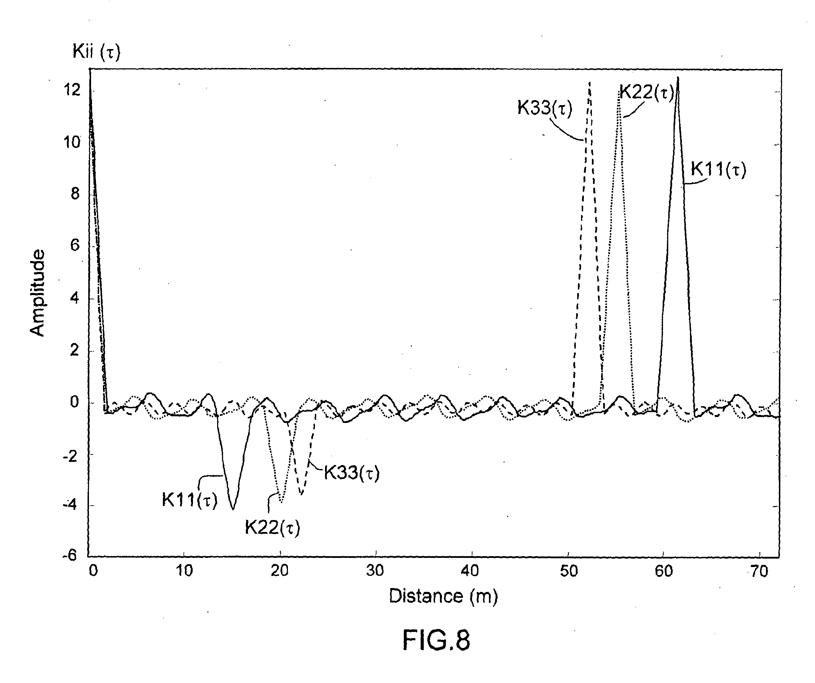

Le diagramme de la figure 8, toujours tracé dans le cas du réseau de la figure 1, sans défaut et ayant ses extrémités adaptées en impédance, montre la superposition des courbes de corrélation Kii($\tau$), ramenées à une même origine $\tau$ = 0. La courbe en traits pleins correspond à une séquence injectée en E1 et observée en E1 ; la courbe en traits pointillés correspond à une séquence injectée en E2 au même moment et observée en E2 ; et la courbe en traits tiretés correspond à une séquence injectée en E3 et observée en E3. Le tronçon L1 fait 15 mètres, les tronçons L2 et L3 font 20 m et 22 m respectivement. La graduation des abscisses est en distance entre le point d'observation et un défaut (c'est-à-dire que la graduation en abscisse ne représente pas la durée de propagation réelle $\tau$ correspondant au pic mais la moitié de cette durée).

Les pics correspondant à la réflexion sur la jonction A sont ici de signe négatif. On trouve un pic pour la corrélation avec la séquence PN1(t) observée en E1, à une distance de 15 mètres correspondant à la longueur L1 du tronçon T1, un pic pour la corrélation avec la séquence PN2(t) observée en E2, à une distance de 20m correspondant à la longueur L2 du tronçon T2, et un pic pour la corrélation avec la séquence PN3(t) observée en E3, à une distance de 22m correspondant à la longueur L3 du tronçon T3.

Les pics de signe positif sont les pics d'auto-corrélation à l'entrée et proviennent de la périodicité de l'injection de la séquence pseudo-aléatoire. Les séquences PN1(t), PN2(t) et PN3(t) sont de durées différentes et donc de périodicités différentes. La dé-corrélation est ici réalisée d'une manière telle que les séquences binaires PN1(t) à PN3(t) sont de durées différentes, ce qui explique les trois positions différentes des pics d'auto-corrélation ; ces durées différentes sont obtenues soit par des séquences de structure identique mais de débit binaire différent, soit par des séquences de longueurs différentes en nombre de bits, donc de structures différentes, et de débit binaire identique ou différent.

Dans l'exemple de la figure 8, les séquences sont de débits différents respectivement PN1(t) : 50 Mbps, PN2 (t) : 55 Mbps, et PN3(t) : 60 Mbps.

La dé-corrélation des séquences pourrait aussi être obtenue en choisissant des séquences de durée identique et période identique, mais dont les polynômes caractéristiques sont différents pour chaque LFSR. Dans ce cas, les pics d'auto-corrélation K11 ($\tau$), K22($\tau$) et K33($\tau$) seraient superposés à chaque période d'injection du signal.

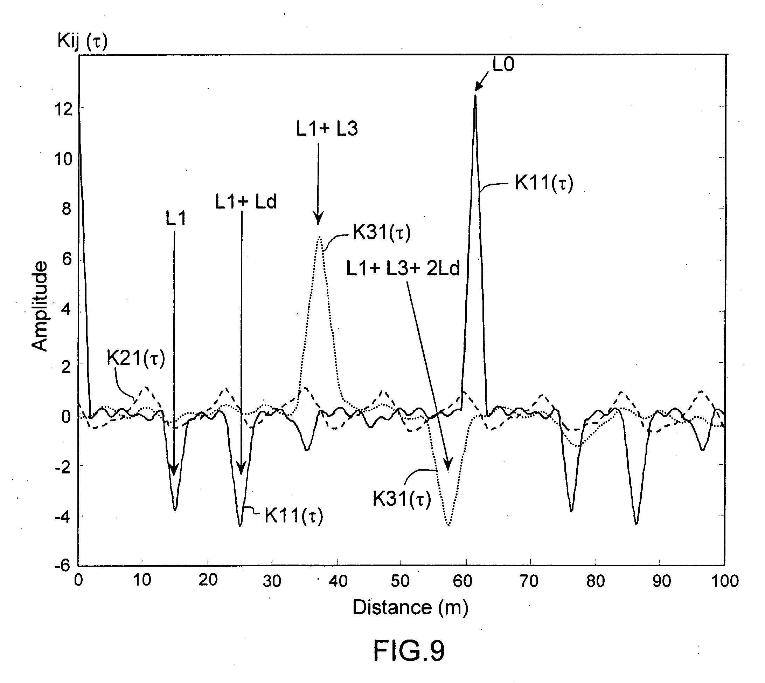

La figure 9 représente toutes les fonctions de corrélation correspondant à un seul point d'observation qui est l'extrémité E1, en présence de l'injection simultanée de séquences différentes PN1(t), PN2(t) et PN3(t) respectivement aux trois extrémités E1, E2, E3. Ces fonctions sont représentées dans le cas de présence d'un défaut dans le tronçon L2.

Pour la lisibilité directe de la figure 9, on notera qu'on a utilisé des graduations d'abscisses différentes selon que la fonction de corrélation représentée est une corrélation avec un signal réfléchi (corrélation de type Kii($\tau$)) ou une corrélation avec un signal transmis directement sans aller-retour (corrélation de type Kij($\tau$) avec i différent de j). Pour une corrélation avec un aller simple, la graduation en distance correspond à la durée de propagation (L=Vp.$\tau$) ; pour une corrélation avec un signal en aller-retour, la graduation en distance correspond à la moitié de la durée de propagation (L=Vp.$\tau$/2). Il s'agit là d'un simple artifice de présentation du diagramme, permettant de placer tous les pics de corrélation à des endroits qui correspondent à des distances physiques (sur le câble) mesurées en aller simple, plutôt que de placer certains pics à des positions correspondant à une durée d'aller-retour alors que d'autres seraient placés à des positions correspondant à une durée d'aller simple.

Sur la figure 9, la courbe en traits pleins, graduée en distances correspondant à $\tau$/2, correspond à la fonction de corrélation K11 ($\tau$) entre la séquence PN1(t) injectée en E1 et le signal composite R1 (t) observé en E1. Il y a un pic d'auto-corrélation de départ à t=0, et un autre à L0 correspondant à la période d'injection T0 des séquences. La longueur L0 sur le graphique correspond à VpT0/2. Il y a un pic intermédiaire négatif à la longueur L1 (15m) comme à la figure 8, correspondant à la position de la jonction A. Mais il y a aussi un pic à environ 25 m. On en déduit qu'il y a un défaut au delà de la jonction A, sur le tronçon T2 ou le tronçon T3, à une distance Ld (d'environ 10m) de la jonction A, défaut qui engendre une réflexion vers l'entrée E1.

La courbe en traits pointillés, graduée en distances correspondant à $\tau$, correspond à la fonction de corrélation K21 ($\tau$) entre la séquence PN2(t) injectée en E2 et le signal composite R1(t) observé en E1. Cette courbe ne présente pratiquement pas de pic de corrélation ; cela veut dire que le signal injecté en E2 n'atteint pas ou pratiquement pas l'entrée E1 ; on en conclut que le défaut dont l'existence a été constatée par la courbe K11($\tau$) est un court-circuit qui interrompt la propagation vers l'extrémité E2.

Le défaut est donc probablement un court-circuit sur le tronçon T2 à la distance Ld d'environ 10 mètres de la jonction A.

La troisième courbe, en traits tiretés, également graduée en distances correspondant à $\tau$, correspond à la fonction de corrélation K31 ($\tau$) entre la séquence PN3(t) injectée en E3 et le signal composite R1 (t) observé en E1. Cette courbe présente un pic positif à la distance L3+L1 (37mètres) montrant un trajet direct (sans défaut) de la séquence de l'extrémité E3 à l'extrémité E1. Elle présente aussi un pic négatif à une distance d'environ 57 mètres. Ce pic résulte apparemment de la propagation suivante de l'extrémité E3 vers l'extrémité E1 : propagation dans le tronçon T3 (L3 : 22m), réflexion partielle en A vers le tronçon T2, propagation sur T2 jusqu'au défaut (Ld : 10m), retour du défaut à la jonction (Ld : 10m), et propagation sur le tronçon T1 (L1 : 15 m). Au total L3+2Ld+L1 = 57 mètres.

La fonction de corrélation K31 ($\tau$) confirme donc sans ambiguïté la présence du défaut sur le tronçon T2, sa nature de court-circuit, et sa position.

On pourrait aussi calculer et tracer les fonctions de corrélation non représentées K22($\tau$), K33($\tau$) comme à la figure 8. Sur la courbe K22($\tau$) on verrait apparaître un pic à une distance L2-Ld, en raison du défaut, à la place du pic à la distance L2 ; sur la courbe K33($\tau$) on verrait apparaître encore le pic à la distance L3 mais aussi un pic à L3+Ld. Ces courbes peuvent servir à confirmer les observations précédentes faites sur la figure 9.

Et on pourrait aussi tracer les fonctions de corrélation K23($\tau$) et K32($\tau$). Dans l'exemple du défaut indiqué ci-dessus, on ne verrait rien sur ces courbes en raison du défaut en court-circuit sur le tronçon T2, qui interdit toute propagation de E2 vers E3 ou l'inverse.

Enfin, on pourrait bien sûr tracer les courbes K12($\tau$) et K13($\tau$) mais on comprendra qu'elles sont redondantes avec les courbes K21 ($\tau$) et K31($\tau$).

Pour mettre en oeuvre l'invention, il faut engendrer des séquences pseudo-aléatoires dé-corrélées entre elles ;

il y a plusieurs manières d'obtenir cette dé-corrélation, comme on l'a indiqué plus haut.

Tout d'abord, si les séquences binaires sont plus longues, il est plus facile de les décorréler entre elles que si elles sont plus courtes. Des séquences de 64 bits ou plus sont préférables.

Ensuite, certains générateurs de séquences pseudo-aléatoires sont conçus pour permettre la production de séquences orthogonales entre elles, c'est-à-dire présentant une inter-corrélation nulle ou très faible par principe quel que soit le décalage temporel entre les séquences. Les codes pseudo-aléatoires de Gold en sont un exemple. De tels codes sont bien connus dans les techniques de positionnement par satellites où ils sont utilisés pour séparer les canaux les uns des autres.

D'autre part, les séquences pseudo-aléatoires de type M (séquences dites "à longueur maximale") engendrées par une cascade de n registres sont très peu corrélées entre elles si elles ont des longueurs (en nombre de bits) différents, c'est-à-dire si le nombre de registres de la cascade est différent d'une séquence à l'autre.

Egalement, les séquences pseudo-aléatoires de type M sont très peu corrélées entre elles et conviennent donc bien si elles ont des débits binaires différents, même si elles ont la même longueur en nombre de bits. Les débits ne doivent pas être multiples l'un de l'autre et, si possible, leur rapport ne doit pas être trop simple lorsque ce rapport est un nombre rationnel : un rapport de débits égal à une fraction rationnelle simplifiée convient si le numérateur et le dénominateur sont suffisamment élevés ; en d'autres mots un rapport de nombres trop petits comme 2/3 ou 3/4 est à éviter ; un rapport de 7/8 ou un rapport de nombres plus grand est préféré. Un rapport égal à un nombre irrationnel est souhaitable à condition bien sûr qu'il ne soit pas très proche des nombres à exclure ci-dessus (nombre entier, fraction rationnelle de numérateur et dénominateur trop petits). Un nombre irrationnel qui diffère d'au moins 5% avec un des nombres à exclure convient bien pour une séquence d'au moins 64 bits. Par exemple, des débits de 50, 55 et 60 Mbps ont été choisis pour l'analyse du réseau à la figure 9.

La mise en oeuvre de l'invention comprend aussi des moyens d'acquisition des signaux composites, de numérisation de ces signaux et de calcul des fonctions de corrélation. Selon un mode de réalisation préféré de l'invention, les sources utilisées pour générer les différentes séquences pseudo-aléatoires sont de débit fixe et identique, pour des raisons de synchronisation et de distribution des horloges. La dé-corrélation est obtenue en utilisant des polynômes caractéristiques distincts.

Le nombre de registres n est adapté en fonction du problème à traiter, et en particulier de la longueur du réseau, ainsi que de la période de test souhaitée.

L'invention permet de détecter, caractériser et localiser des défauts d'un réseau filaire, même s'il a une topologie complexe. Elle permet d'ailleurs d'identifier la topologie exacte en l'absence de défaut (mesures précises de longueurs de tronçons, etc.). L'analyse du réseau peut être faite lors de l'utilisation normale du réseau, en particulier pour des réseaux de transport d'énergie, mais aussi pour des réseaux de communications, à condition cependant que les débits binaires des séquences pseudo-aléatoires soient suffisamment différents des débits de communications normales du réseau.

Dans le cas d'un réseau de topologie plus complexe que celui de la figure 1, le moyen de diagnostic est composé d'un certain nombre de systèmes conformes à l'invention tels que ceux décrits plus haut, répartis en des endroits bien choisis dans le réseau afin qu'ils puissent surveiller des sous-réseaux de topologie plus simple, se ramenant par exemple à celle de la figure 1.

**Revendications**

1.  Procédé de test d'un réseau de câbles comportant au moins une jonction d'où partent N tronçons secondaires (N supérieur ou égal à 2), le procédé comprenant les opérations suivantes :

    - injecter dans le réseau, en plusieurs points d'injection Ei, des séquences pseudo-aléatoires de signaux numériques PNi(t),
    - recueillir, en un ou plusieurs points d'observation Sj, des signaux temporels composites Rj(t) engendrés par la circulation des séquences émises et leurs réflexions dans les discontinuités d'impédance du réseau,
    - calculer une fonction de corrélation Kij($\tau$), en chacun des points d'observation Sj et pour chaque point d'injection Ei, cette fonction représentant, en fonction d'un retard variable $\tau$, une valeur de corrélation temporelle entre d'une part le signal composite Rj(t) présent en ce point d'observation et d'autre part des séquences pseudo-aléatoires PNi(t-$\tau$) identiques aux séquences PNi(t) qui sont injectées aux différents points mais retardées du retard variable $\tau$,
    - rechercher des valeurs caractéristiques de $\tau$ pour lesquelles la courbe de corrélation Kij($\tau$) présente un pic,
    - déterminer les positions de défauts du câble en fonction des valeurs caractéristiques trouvées pour chaque corrélation Kij($\tau$),
    - les séquences pseudo-aléatoires injectées aux différents points étant non corrélées entre elles.

**2.** Procédé selon la revendication 1, **caractérisé en ce que** les séquences sont des séquences dites "à longueur maximale" ou séquences M produites par une cascade de n registres à décalage avec des rebouclages.

**3.** Procédé selon l'une des revendications 1 et 2, **caractérisé en ce que** les séquences pseudo-aléatoires ont des débits binaires différents.

**4.** Procédé selon la revendication 3, **caractérisé en ce que** le rapport des débits binaires entre deux séquences pseudo-aléatoires est un nombre irrationnel, ou une fraction rationnelle de nombres entiers.

**5.** Procédé selon l'une des revendications 2 ou 3, **caractérisé en ce que** les séquences pseudo-aléatoires ont des longueurs, en nombre de bits, différentes.

**6.** Procédé selon l'une des revendications 1 ou 2, **caractérisé en ce que** les séquences pseudo-aléatoires sont des séquences orthogonales entre elles, présentant par nature une inter-corrélation mutuelle pratiquement nulle quel que soit leur décalage temporel.

**7.** Procédé selon la revendication 6, **caractérisé en ce que** chaque séquence pseudo-aléatoire correspond à un polynôme caractéristique primitif de degré n.

**8.** Procédé selon la revendication 6, **caractérisé en ce que** le ratio d'inter-corrélation entre deux séquences est inférieur à 10 % :

$$(\text{MaxIntercorrélation-MinIntercorrélation})/(\text{MaxAutocorrélation}) <= 0{,}10$$

**9.** Dispositif de test d'un réseau de câbles comportant au moins une jonction d'où partent N tronçons secondaires (N supérieur ou égal à 2), **caractérisé en ce qu'**il comporte au moins deux sources de séquences pseudo-aléatoires de signaux numériques non corrélées entre elles et aptes à être raccordées en deux points d'un réseau à tester, des moyens de synchronisation des sources entre elles, un dispositif de détection du signal composite présent en au moins un point du réseau, et des moyens de calcul de la fonction de corrélation entre ce signal et chacune des séquences pseudo-aléatoires retardées d'un retard variable ($\tau$).

**Claims**

**1.** A method of testing a cable network comprising at least one junction from which N secondary sections (N being greater than or equal to 2) extend, the method comprising the following operations:

- injecting into the network, at a plurality of injection points Ei, pseudo-random sequences of digital signals PNi(t),
- collecting, at one or more observation points Sj, composite time signals Rj(t) generated by the circulation of the output sequences and their reflections in the impedance discontinuities of the network,
- computing a correlation function Kij($\tau$), at each of the observation points Sj and for each injection point Ei, this function representing, according to a variable delay $\tau$, a time correlation value between on the one hand the composite signal Rj(t) present at this observation point and on the other hand pseudo-random sequences PNi (t-$\tau$) identical to the sequences PNi(t) that are injected at the different points but delayed by the variable delay $\tau$,
- searching for characteristic values of $\tau$ for which the correlation curve Kij($\tau$) presents a peak,
- determining the positions of cable defects according to the characteristic values found for each correlation Kij($\tau$),
- the pseudo-random sequences injected at the different points being mutually non-correlated.

**2.** The method as claimed in claim 1, **characterized in that** the sequences are "maximum length" sequences or sequences M produced by a cascade of n shift registers with loopbacks.

**3.** The method as claimed in one of claims 1 or 2, **characterized in that** the pseudo-random sequences have different bit rates.

**4.** The method as claimed in claim 3, **characterized in that** the ratio of the bit rates between two pseudo-random sequences is an irrational number, or a rational fraction of integer numbers.

5. The method as claimed in one of claims 2 or 3, **characterized in that** the pseudo-random sequences have different lengths, expressed in number of bits.

6. The method as claimed in one of claims 1 or 2, **characterized in that** the pseudo-random sequences are mutually orthogonal sequences, inherently presenting a mutual inter-correlation that is almost zero regardless of their time offset.

7. The method as claimed in claim 6, **characterized in that** each pseudo-random sequence corresponds to an nth degree primitive characteristic polynomial.

8. The method as claimed in claim 6, **characterized in that** the inter-correlation ratio between two sequences is less than 10%:

$$(MaxIntercorrelation-MinIntercorrelation)/(MaxSelf-correlation)<=0.10$$

9. A device for testing a cable network comprising at least one junction from which N secondary sections (N being greater than or equal to 2) extend, **characterized in that** it comprises at least two sources of pseudo-random sequences of digital signals that are mutually non-correlated and able to be connected at two points of a network to be tested, means of synchronizing the sources with each other, a device for detecting the composite signal present at at least one point of the network, and means of computing the correlation function between this signal and each of the pseudo-random sequences delayed by a variable delay ($\tau$).

**Patentansprüche**

1. Verfahren zum Testen eines Kabelnetzes, das wenigstens eine Verbindungsstelle umfasst, von der N sekundäre Sektionen (wobei N gleich oder größer als 2 ist) abgehen, wobei das Verfahren die folgenden Operationen beinhaltet:

- Injizieren in das Netz, an mehreren Injektionsstellen Ei, von pseudozufälligen Sequenzen von digitalen Signalen PNi(t),
- Sammeln, an einer oder mehreren Beobachtungsstellen Sj, von zusammengesetzten Zeitsignalen Rj(t), die durch den Umlauf von emittierten Sequenzen und deren Reflexionen in den Impedanzdiskontinuitäten des Netzes erzeugt werden,
- Berechnen einer Korrelationsfunktion Kij($\tau$) an jeder der Beobachtungsstellen Sj und für jede Injektionsstelle Ei, wobei diese Funktion in Abhängigkeit von einer variablen Verzögerung $\tau$ einen zeitlichen Korrelationswert zwischen dem an dieser Beobachtungsstelle anliegenden zusammengesetzten Signal Rj(t) einerseits und mit den Sequenzen PNi(t) identischen pseudozufälligen Sequenzen PNi(t-$\tau$) andererseits repräsentiert, die an den verschiedenen Punkten injiziert werden, aber um die variable Verzögerung $\tau$ verzögert,
- Suchen nach charakteristischen Werten von $\tau$, für die die Korrelationskurve Kij($\tau$) eine Spitze aufweist,
- Bestimmen der Störungspositionen des Kabels in Abhängigkeit der für jede Korrelation Kij($\tau$) gefundenen charakteristischen Werte,
- wobei die an den verschiedenen Punkten injizierten pseudozufälligen Sequenzen untereinander nicht korreliert sind.

2. Verfahren nach Anspruch 1, **dadurch gekennzeichnet, dass** die Sequenzen Sequenzen "maximaler Länge" oder M-Sequenzen sind, die von einer Kaskade von n rückgekoppelten Schieberegistern erzeugt wurden.

3. Verfahren nach einem der Ansprüche 1 und 2, **dadurch gekennzeichnet, dass** die pseudozufälligen Sequenzen unterschiedliche Bitraten haben.

4. Verfahren nach Anspruch 3, **dadurch gekennzeichnet, dass** das Bitratenverhältnis zwischen zwei pseudozufälligen Sequenzen eine irrationale Zahl oder ein rationaler Bruchteil von ganzen Zahlen ist.

5. Verfahren nach Anspruch 2 oder 3, **dadurch gekennzeichnet, dass** die pseudozufälligen Sequenzen nach Bitzahlen unterschiedliche Längen haben.

**6.** Verfahren nach Anspruch 1 oder 2, **dadurch gekennzeichnet, dass** die pseudozufälligen Sequenzen zueinander orthogonale Sequenzen sind, die nach ihrer Natur eine gegenseitige Interkorrelation von praktisch null aufweisen, unabhängig von ihrer Zeitverschiebung.

**7.** Verfahren nach Anspruch 6, **dadurch gekennzeichnet, dass** jede pseudozufällige Sequenz einem primitiven charakteristischen Polynom mit Grad n entspricht.

**8.** Verfahren nach Anspruch 6, **dadurch gekennzeichnet, dass** das Interkorrelationsverhältnis zwischen zwei Sequenzen kleiner als 10 % ist:

$$(MaxInterkorrelation - MinInterkorrelation)/(MaxAutokorrelation) <= 0,10$$

**9.** Vorrichtung zum Testen eines Kabelnetzes, das wenigstens eine Verbindungsstelle umfasst, von der N sekundäre Sektionen (wobei N gleich oder größer als 2 ist) abgehen, **dadurch gekennzeichnet, dass** sie wenigstens zwei Quellen von pseudozufälligen Sequenzen von untereinander nicht korrelierten digitalen Signalen umfasst, die an zwei Punkte eines zu testenden Netzes angeschlossen werden können, Mittel zum Synchronisieren der Quellen untereinander, eine Vorrichtung zum Erkennen des zusammengesetzten Signals, das an wenigstens einem Punkt des Netzes anliegt, und Mittel zum Berechnen der Korrelationsfunktion zwischen diesem Signal und jeder der um eine variable Verzögerung ($\tau$) verzögerten pseudozufälligen Sequenzen.

FIG.1

FIG.2

FIG.3

FIG.4

E1 · L1 · T1 · L2 · T2 · E2 · T3 · L3 · E3

t

Reg 1 · Reg 2 · Reg 3 · Reg 4 · Reg 5 · Reg 6

τ

0

PN (t)

FIG.5

R (t)

FIG.6

K11(τ)

FIG.7

EP 2 082 247 B1

FIG.8

EP 2 082 247 B1

FIG.9

EP 2 082 247 B1

## EP 2 082 247 B1

**Documents brevets cités dans la description**

- WO 02068968 A
- WO 2004005947 A
- US 5369366 A

**Littérature non-brevet citée dans la description**

- **Cynthia Furse.** Spread Spectrum Sensors for Critical Fault Location on Live Wire Networks. *Journal of Structural Control and Health Monitoring,* 2005, vol. 12 (3-4